# FASCICULE DE BREVET EUROPEEN

(11) **EP 3 404 723 B1**
(45) Date de publication et mention de la délivrance du brevet: **31.03.2021**
(21) Numéro de dépôt: 18172456.8
(22) Date de dépôt: 15.05.2018
(51) Int. Cl.: H01L 29/778, H01L 21/336, H01L 29/417, H01L 29/16, H01L 29/24

(54) **RÉALISATION D'UN TRANSISTOR MOS À BASE D'UN MATÉRIAU SEMICONDUCTEUR BIDIMENSIONNEL**
HERSTELLUNG EINES MOS-TRANSISTORS AUF DER BASIS EINES 2D-HALBLEITERMATERIALS
PRODUCTION OF A MOS TRANSISTOR USING A TWO-DIMENSIONAL SEMICONDUCTOR MATERIAL

(30) Priorité: 18.05.2017 FR 1754386
(43) Date de publication de la demande: 21.11.2018
(73) Titulaire: Commissariat à l'Energie Atomique et aux Energies Alternatives, 75015 Paris (FR)
(72) Inventeur: NEMOUCHI, Fabrice, 38430 MOIRANS (FR); MORAND, Yves, 38000 GRENOBLE (FR)
(74) Mandataire: Cabinet Beaumont

(56) Documents cités:
- US-A1- 2009 020 764
- US-A1- 2011 291 184
- US-A1- 2014 353 589

## Description

### Domaine

La présente demande concerne la réalisation d'un transistor MOS à base d'un matériau semiconducteur bidimensionnel.

### Exposé de l'art antérieur

Un matériau bidimensionnel est un matériau cristallin constitué d'un empilement d'un ou plusieurs feuillets constitués chacun d'une seule couche d'atomes ou de molécules. Les atomes ou molécules d'un même feuillet sont relativement fortement liés par des liaisons covalentes, tandis que les atomes ou molécules de feuillets voisins sont relativement faiblement liés par des liaisons de type liaison de Van der Waals.

Les matériaux semiconducteurs bidimensionnels sont jugés prometteurs dans le domaine de la nanoélectronique, dans la mesure où ils permettent d'obtenir des couches cristallines très peu épaisses. Ceci permet notamment d'envisager la réalisation de composants semiconducteurs de dimensions nanométriques sur des substrats de support de diverses natures, par exemple des substrats en verre ou en plastique, en utilisant un matériau bidimensionnel déposé comme matériau semiconducteur.

L'article intitulé "MoS2 U-shape MOSFET with 10 nm Channel Length and Poly-Si Source/Drain Serving as Seed for Full Wafer CVD MoS2 Availability" de Kai-Shin Li et al. (Symposium on VLSI Technology, 2016 IEEE), décrit un procédé de fabrication d'un transistor MOS dans lequel la région de canal est en disulfure de molybdène (MoS₂) cristallin, qui est un matériau semiconducteur bidimensionnel, déposé sur un support d'oxyde de silicium.

Ce procédé présente toutefois des inconvénients. En particulier, il comprend deux étapes de photolithographie distinctes, respectivement pour délimiter les régions de source et de drain du transistor, et pour délimiter la grille du transistor. Autrement dit, la grille du transistor n'est pas auto-alignée sur les régions de source et de drain. Il en résulte que la grille du transistor s'étend non seulement au-dessus de la région de canal du transistor, mais aussi au-dessus d'une partie de la région de source et au-dessus d'une partie de la région de drain du transistor. Ceci conduit à augmenter l'encombrement global du transistor.

Le document US2009/020764 décrit quant à lui un transistor à base de graphène. Lors de sa fabrication, le graphène est déposé sur un substrat ayant une tranchée dans laquelle sera formée la grille.

### Résumé

Ainsi, un mode de réalisation prévoit un procédé de fabrication d'un transistor MOS, comprenant les étapes successives suivantes :
a) former une première couche en un matériau conducteur ou semiconducteur sur une face d'un substrat de support ;
b) former une grille sacrificielle sur la face supérieure de la première couche, et une deuxième couche en un matériau isolant entourant latéralement la grille sacrificielle ;
c) former, de part et d'autre de la grille sacrificielle, des éléments de connexion électrique de source et de drain en un matériau conducteur, traversant la deuxième couche et venant contacter la première couche ;
d) retirer la grille sacrificielle et la portion de la première couche située à l'aplomb de la grille sacrificielle ;
e) déposer une troisième couche en un matériau semiconducteur bidimensionnel sur les flancs et sur le fond d'une ouverture formée à l'étape d) par le retrait de la grille sacrificielle et de la première couche ;
f) déposer une quatrième couche en un matériau isolant sur la troisième couche ; et
g) former une grille conductrice dans l'ouverture, sur la quatrième couche.

Selon un mode de réalisation, le matériau semiconducteur bidimensionnel de la troisième couche est un matériau du groupe comprenant le graphène, le siliciène, le germanène, et les dichalcogénures de métaux de transition.

Selon un mode de réalisation, la troisième couche est constituée d'un empilement de 1 à 10 feuillets cristallins bidimensionnels constitués chacun d'une seule couche d'atomes ou de molécules du matériau semiconducteur bidimensionnel.

Selon un mode de réalisation, à l'étape d), le retrait de la portion de la première couche en regard de la grille sacrificielle conduit à délimiter dans la première couche la région de source et la région de drain du transistor.

Selon un mode de réalisation, l'étape g) comprend une étape de dépôt d'un ou plusieurs matériaux conducteurs de grille sur toute la surface supérieure de la structure obtenue à l'issue de l'étape f), suivie d'une étape de planarisation par polissage mécano-chimique pour retirer le ou les matériaux conducteurs de grille en dehors de l'ouverture.

Selon un mode de réalisation, aux étapes e) et f), les troisième et quatrième couches sont déposées sur toute la surface supérieure de la structure obtenue à l'issue de l'étape d), et l'étape de planarisation mise en oeuvre à l'étape g) conduit à retirer les troisième et quatrième couches en dehors de l'ouverture.

Selon un mode de réalisation, le procédé comprend en outre, à l'étape b), après la formation de la grille sacrificielle et avant le dépôt de la deuxième couche, une étape de formation d'espaceurs en un matériau isolant revêtant les flancs de la grille sacrificielle.

Selon un mode de réalisation, à l'étape d), la grille sacrificielle est retirée sélectivement par rapport aux espaceurs.

Selon un mode de réalisation, les éléments de connexion électrique de source et de drain formés à l'étape c) sont auto-alignés par rapport à la grille sacrificielle.

La présente description décrit également un transistor MOS comprenant :
des régions de source et de drain formées dans une première couche conductrice ou semiconductrice ;
une région de canal en un matériau semiconducteur bidimensionnel, séparant la région de source de la région de drain ;
une couche diélectrique revêtant la région de canal entre les régions de source et de drain ; et
une grille conductrice surmontant la couche diélectrique entre les régions de source et de drain,
dans lequel la grille conductrice est auto-alignée par rapport aux régions de source et de drain.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1A à 1H sont des vues en coupe illustrant des étapes d'un exemple d'un procédé de fabrication d'un transistor MOS selon un mode de réalisation ;
la figure 2 est une vue en coupe illustrant une variante du procédé des figures 1A à 1H ; et
les figures 3A et 3B sont des vues en coupe illustrant une autre variante du procédé des figures 1A à 1H.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, les diverses applications que peuvent avoir les transistors décrits n'ont pas été détaillées.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des figures, étant entendu que, dans la pratique les structures décrites peuvent être orientées différemment. Sauf précision contraire, les expressions "approximativement", "sensiblement", et "de l'ordre de" signifient à 10 % près, de préférence à 5 % près.

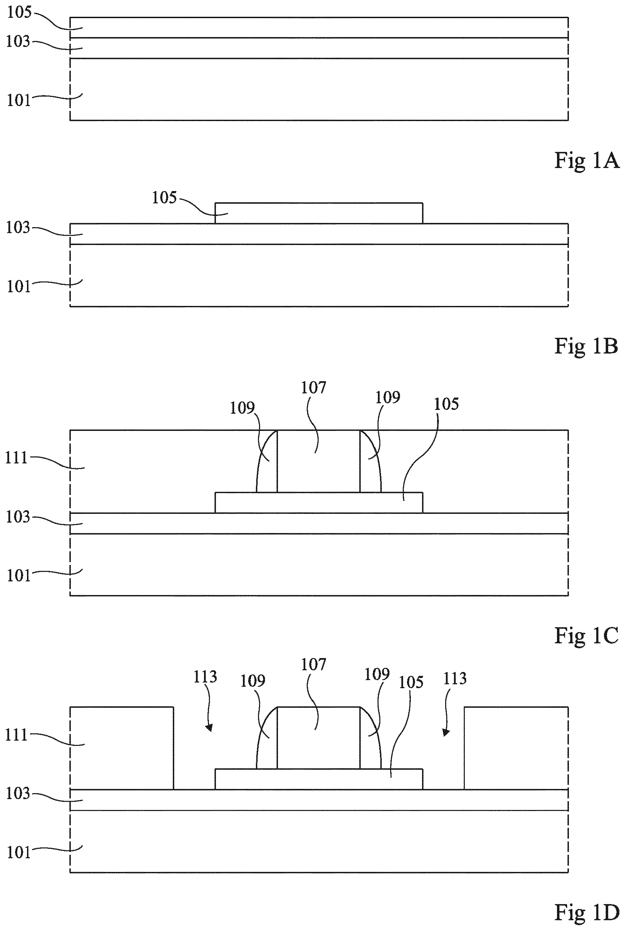

Les figures 1A à 1H sont des vues en coupe illustrant des étapes successives d'un exemple d'un procédé de fabrication d'un transistor MOS dont la région de canal est en un matériau bidimensionnel. Bien que les figures 1A à 1H représentent la réalisation d'un unique transistor, on comprendra qu'en pratique, un grand nombre de transistors, par exemple identiques ou similaires, peuvent être formés simultanément sur un même substrat de support.

La figure 1A illustre une étape initiale de dépôt d'une couche isolante 103 sur la face supérieure d'un substrat de support 101. Le substrat 101 peut être un substrat silicium massif, un substrat de type silicium sur isolant, un substrat en verre, un substrat en plastique, ou tout autre substrat de support adapté, rigide ou souple. La couche isolante 103 est par exemple une couche d'oxyde de silicium (SiO₂), une couche de nitrure de silicium (SiN), une couche d'alumine (Al₂O₃), une couche d'oxyde d'hafnium (HfO₂), ou une couche de nitrure d'aluminium (AIN). L'épaisseur de la couche isolante 103 est par exemple comprise entre 2 et 500 nm et de préférence entre 2 et 10 nm.

La figure 1A illustre en outre une étape de dépôt, sur la face supérieure de la couche isolante 103, d'une couche conductrice ou semiconductrice 105 dans laquelle seront ultérieurement formées les régions de source et de drain du transistor. La couche 105 est par exemple en un matériau semiconducteur dopé, par exemple du silicium, du germanium ou du silicium-germanium. A titre de variante, la couche 105 est en un matériau conducteur, par exemple un métal, par exemple du tungstène, de l'aluminium ou du nitrure de titane. A titre de variante, la couche 105 est en un siliciure ou un germaniure. L'épaisseur de la couche 105 est par exemple comprise entre 10 et 100 nm.

Dans cet exemple, les couches 103 et 105 sont déposées sur sensiblement toute la surface supérieure du substrat de support 101.

La figure 1B illustre une étape de retrait localisé de la couche 105 de façon à ne conserver qu'une portion de la couche 105 correspondant aux futures régions de source et de drain du transistor. A ce stade, la portion conservée de la couche 105 s'étend en outre en regard de la future région de canal du transistor. Le retrait localisé de la couche 105 peut être réalisé par photolithographie et gravure, par exemple par gravure humide ou sèche. Lors de cette étape, la couche isolante 103 est conservée sur toute la surface supérieure du substrat 101.

La figure 1C illustre une étape de formation d'une grille sacrificielle 107 sur la face supérieure de la portion de la couche 105 conservée à l'étape de la figure 1B, à l'emplacement de la future grille du transistor. La grille sacrificielle 107 est par exemple en un matériau gravable sélectivement par rapport au matériau de la couche 105. A titre d'exemple, dans le cas où la couche 105 est en métal, la grille sacrificielle 107 peut être en silicium ou en germanium. Une couche du matériau constituant la grille sacrificielle est par exemple dans un premier temps déposée sur toute la surface supérieure du substrat 101, puis retirée localement par photolithographie et gravure de façon à conserver uniquement la grille sacrificielle 107. L'épaisseur (ou hauteur) de la grille sacrificielle 107 est par exemple comprise entre 20 et 100 nm. En vue de dessus, la grille sacrificielle traverse par exemple de part en part la portion de la couche 105 conservée à l'étape de la figure 1B, de façon à délimiter dans ladite portion les régions de source et de drain du transistor. A titre d'exemple, la grille sacrificielle 107 a, vu de dessus, la forme d'un barreau rectiligne traversant de part en part la portion de couche 105 conservée à l'étape de la figure 1B.

La figure 1C illustre en outre la formation d'espaceurs 109 en un matériau diélectrique, par exemple en SiN ou en SiCBN, revêtant les flancs de la grille sacrificielle 107. A titre d'exemple, une couche du matériau diélectrique constituant les espaceurs 109 est dans un premier temps déposée par dépôt conforme sur toute la surface supérieure de la structure après la formation de la grille sacrificielle 107, puis une étape de gravure anisotrope de cette couche est mise en oeuvre de façon à conserver le matériau diélectrique uniquement sur les flancs de la grille sacrificielle 107. A titre d'exemple, les espaceurs 109 ont une épaisseur comprise entre 5 et 20 nm, et s'étendent sur sensiblement toute la hauteur de la grille sacrificielle 107. Le matériau des espaceurs 109 est de préférence choisi de façon que la grille sacrificielle 107 soit gravable sélectivement par rapport aux espaceurs.

La figure 1C illustre de plus une étape de formation d'une couche isolante d'encapsulation 111, par exemple en oxyde de silicium, entourant latéralement la grille sacrificielle 107 et les espaceurs 109, et s'étendant sur sensiblement toute la hauteur de la grille sacrificielle 107 de façon à laisser accessible uniquement la face supérieure de la grille sacrificielle 107 et, le cas échéant, des espaceurs 109. A titre d'exemple, une couche du matériau d'encapsulation est d'abord déposée sur toute la surface supérieure de la structure (après la formation de la grille sacrificielle 107 et des espaceurs 109) sur une épaisseur supérieure à celle de la grille sacrificielle 107, par exemple sur une épaisseur comprise entre 50 et 500 nm. Une étape de planarisation de la face supérieure de la structure, par exemple par polissage mécano-chimique, est ensuite mise en oeuvre de façon à retirer l'excès de matériau d'encapsulation. L'étape de planarisation est interrompue lorsque la face supérieure de la grille sacrificielle 107 est découverte comme représenté en figure 1C.

La figure 1D illustre une étape de formation d'ouvertures 113 dans la couche d'encapsulation 111, de part et d'autre de la grille sacrificielle 107, en regard des régions de source et de drain du transistor, en vue d'une étape ultérieure de reprise de contact électrique sur les régions de source et de drain. Les ouvertures 113 sont par exemple formées par lithographie et gravure, et débouchent sur la face supérieure de la portion de couche 105 conservée à l'étape de la figure 1B.

A titre d'exemple, la région exposée à la gravure lors de la réalisation des ouvertures 113 englobe la grille sacrificielle 107 et les espaceurs 109, ainsi que tout ou partie de la portion de la couche 105 non surmontée par la grille sacrificielle 107 et par les espaceurs 109. Dans ce cas, la méthode de gravure utilisée est choisie pour être sélective vis-à-vis de la grille sacrificielle 107 et des espaceurs 109, de façon à permettre de retirer le matériau d'encapsulation sans retirer la grille sacrificielle 107 et les espaceurs 109. Un avantage est que les contacts de source et de drain du transistor seront alors auto-alignés par rapport à la grille sacrificielle 107 et aux espaceurs 109.

Dans l'exemple représenté, la région exposée à la gravure lors de la réalisation des ouvertures 113 englobe la totalité de la portion de la couche 105 conservée à l'étape de la figure 1B, et s'étend en outre latéralement au-delà de la couche 105, de part et d'autre de la grille sacrificielle 107. Autrement dit, dans cet exemple, les régions de contact de source et de drain du transistor sont plus longues que les régions de source et de drain à contacter.

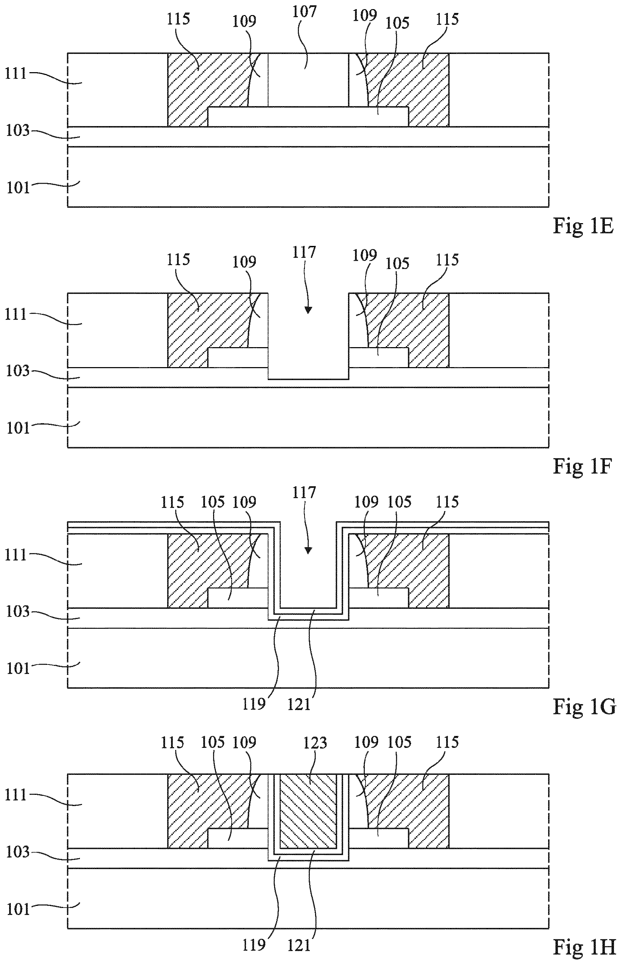

La figure 1E illustre une étape de remplissage des ouvertures 113 formées à l'étape de la figure 1D, par un matériau conducteur, par exemple un métal, par exemple du tungstène, du cobalt, du cuivre, du titane, du nitrure de titane, du tantale, du nitrure de tantale ou une combinaison de ces derniers (par exemple Ti/TiN/W ou Ta/TaN/Cu), pour former les contacts de source et de drain 115 du transistor. A titre d'exemple, les contacts de source et de drain 115 sont réalisés par dépôt chimique en phase vapeur (CVD). Alternativement, la formation des contacts de source et de drain 115 comprend une première étape de pulvérisation (PVD) d'une couche conductrice d'accroche sur les parois latérales et sur le fond des ouvertures 113, suivie d'une étape de remplissage des ouvertures 113 par un matériau conducteur, par exemple par CVD. En fonction des matériaux utilisés, une couche barrière conductrice, par exemple une couche en nitrure de titane, peut éventuellement être déposée sur les parois latérales et sur le fond des ouvertures 113 avant le remplissage des ouvertures, pour éviter la diffusion du matériau conducteur des contacts 115 dans la couche d'encapsulation 111 et/ou dans les espaceurs 109 et/ou dans la couche 105.

A titre d'exemple, le ou les matériaux conducteurs de formation des contacts de source et de drain sont d'abord déposés sur toute la surface supérieure de la structure, sur une épaisseur supérieure ou égale à la profondeur des ouvertures 113. Une étape de planarisation de la face supérieure de la structure, par exemple par polissage mécano-chimique, est ensuite mise en oeuvre de façon à retirer le ou les matériaux conducteurs en dehors des ouvertures 113. L'étape de planarisation est interrompue lorsque la face supérieure de la grille sacrificielle 107 est découverte. Un léger surpolissage peut être prévu comme représenté sur la figure 1E, pour éviter tout risque de court-circuit entre les contacts de source et de drain 115 et la future grille conductrice du transistor.

La figure 1F illustre une première étape de retrait de la grille sacrificielle 107. A titre d'exemple, la grille sacrificielle 107 est retirée par gravure chimique. La méthode de gravure employée pour retirer la grille sacrificielle 107 est de préférence sélective vis-à-vis du matériau formant les espaceurs 109, de façon à retirer la grille sacrificielle sans endommager les espaceurs. La gravure est par exemple interrompue au niveau de la face supérieure de la couche 105.

La figure 1F illustre en outre une deuxième étape postérieure au retrait de la grille sacrificielle 107, au cours de laquelle la portion de la couche 105 située à l'aplomb de la grille sacrificielle 107 est retirée, de façon à isoler la région de source de la région de drain du transistor. Pour cela, une deuxième gravure peut être mise en oeuvre, cette deuxième gravure pouvant être interrompue sur la face supérieure ou dans la couche isolante 103, ou encore sur la face supérieure ou dans le substrat 101 (dans le cas où le substrat 101 est en un matériau isolant). Dans un mode de réalisation préféré, la gravure est interrompue sensiblement au niveau de la face supérieure de la couche isolante 103, de façon à aligner les régions de source et de drain formées dans la couche 105 sur la partie plane de la future région de canal du transistor.

A titre de variante, le retrait de la grille sacrificielle 107 et le retrait de la portion de couche 105 située sous la grille sacrificielle 107 peuvent être réalisés lors d'une même étape de gravure.

On désigne ici par la référence 117 l'ouverture formée dans la structure par le retrait de la grille sacrificielle 107 et de la portion de la couche 105 située sous la grille sacrificielle 107.

La figure 1G illustre une étape de dépôt, sur les parois latérales et sur le fond de l'ouverture 117, d'une couche 119 d'un matériau semiconducteur bidimensionnel destiné à former la région de canal du transistor. En particulier, la couche 119 déposée à l'étape de la figure 1G vient en contact avec les flancs des régions de source et de drain du transistor, définies à l'étape précédente dans la couche 105. Dans un mode de réalisation préféré, le matériau bidimensionnel utilisé pour former la région de canal est un matériau du groupe des dichalcogénures de métaux de transition, par exemple du WS₂, du MoS₂, du WSe₂ ou du MoSe₂. A titre de variante, le matériau bidimensionnel utilisé peut être du graphène, du silicène, du germanène, ou tout autre matériau bidimensionnel adapté. A titre d'exemple, la couche de matériau bidimensionnel 119 est déposée sur toute la surface supérieure de la structure obtenue à l'issue des étapes de la figure 1F, par exemple par CVD. La couche de matériau bidimensionnel 119 a par exemple une épaisseur comprise entre 1 et 5 nm. A titre d'exemple, la couche 119 est constituée d'un empilement de 1 à 10 feuillets cristallins bidimensionnels constitués chacun d'une seule couche d'atomes ou de molécules.

La figure 1G illustre en outre une étape de dépôt, sur la face supérieure de la couche de matériau bidimensionnel 109, d'une couche 121 en un matériau diélectrique destiné à former l'isolant de grille du transistor. A titre d'exemple, la couche diélectrique 121 est en Al₂O₃, en HfO₂ ou en ZrO₂. La couche 121 a par exemple une épaisseur comprise entre 1 et 5 nm. La couche 121 est par exemple déposée sur toute la surface supérieure de la structure, par exemple par dépôt en couches monatomiques successives (ALD) ou par CVD.

La figure 1H illustre une étape de remplissage de l'ouverture 117 par un matériau conducteur, suite au dépôt des couches 119 et 121, pour former la grille conductrice 123 du transistor. La grille 123 peut être constituée d'un empilement d'une ou plusieurs couches métalliques, par exemple du groupe comprenant le tungstène, le cobalt, le cuivre, l'aluminium et le nitrure de titane. L'empilement de grille est par exemple déposé par CVD, ou par PVD puis CVD. A titre d'exemple, l'empilement de grille est d'abord déposé sur toute la surface de la structure obtenue à l'issue des étapes de la figure 1G, sur une épaisseur supérieure à la profondeur de l'ouverture 117. Une étape de planarisation de la face supérieure de la structure, par exemple par polissage mécano-chimique, est ensuite mise en oeuvre de façon à retirer le ou les métaux de grille, ainsi que les couches 119 et 121, en dehors de l'ouverture 117. Selon le matériau bidimensionnel utilisé pour former la région de canal 119 du transistor, une couche adaptée à ajuster les propriétés de transport de charges de la couche 119 peut éventuellement être déposée avant la formation de l'empilement de grille 123. De plus, selon les matériaux utilisés, une couche barrière peut être prévue entre la grille 123 et la couche diélectrique 121, pour éviter la diffusion du ou des matériaux de l'empilement de grille dans la couche diélectrique 121 et/ou dans la couche 119.

La figure 1H représente le transistor obtenu à l'issue du procédé de fabrication. Un avantage de ce procédé est que le transistor réalisé comprend une grille auto-alignée sur les régions de source et de drain du transistor. Autrement dit, la grille 123 du transistor ne déborde pas latéralement au-dessus des régions de source et de drain du transistor, ce qui limite l'encombrement global du transistor. Ceci résulte du fait que, dans le procédé des figures 1A à 1H, les régions de source et de drain et la région de grille du transistor sont délimitées lors d'une même étape de photolithographie, qui correspond à l'étape de délimitation de la grille sacrificielle 107 décrite en relation avec la figure 1C.

Un autre avantage est que les régions de contact de source et de drain 115 sont sensiblement dans le même plan (horizontalement) que la région de contact de grille du transistor, ce qui simplifie la réalisation des interconnexions du transistor à d'autres éléments de circuit.

Par ailleurs, un autre avantage du procédé décrit est que le matériau semiconducteur bidimensionnel utilisé pour former la région de canal du transistor est déposé seulement dans les toutes dernières étapes du procédé, et en particulier après la formation des contacts de source et de drain du transistor. Ceci permet de réduire les risques d'endommager le matériau semiconducteur, qui est généralement très sensible aux manipulations diverses du fait de sa structure bidimensionnelle.

A titre d'exemple, la longueur de grille (distance source-drain) du transistor réalisé est comprise entre 5 et 30 nm, par exemple de l'ordre de 10 nm. Les régions de contact de source et de drain 115 du transistor ont par exemple chacune une longueur (dans la direction de la longueur de grille du transistor) comprise entre 5 et 30 nm, par exemple de l'ordre de 10 nm.

On notera que dans l'exemple décrit ci-dessus en relation avec les figures 1A à 1H, les régions de source et de drain du transistor, formées dans la couche 105, ont chacune une longueur inférieure à la longueur de la région de contact de source ou de drain 115 correspondante. Les modes de réalisation décrits ne se limitent toutefois pas à ce cas particulier. A titre de variante, chacune des régions de source et de drain du transistor peut avoir une longueur sensiblement égale, voire supérieure à la longueur de la région de contact 115 correspondante.

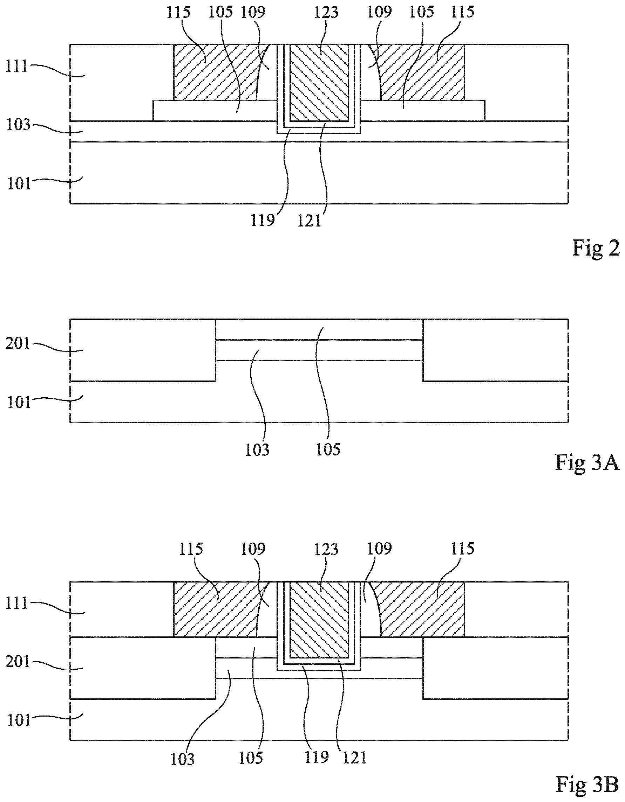

La figure 2 illustre une variante de réalisation du transistor de la figure 1H, dans laquelle chacune des régions de source et de drain du transistor a une longueur supérieure à la longueur de la région de contact de source ou de drain 115 correspondante.

Les figures 3A et 3B illustrent une autre variante du procédé des figures 1A à 1H. Cette variante comprend des étapes communes avec le procédé des figures 1A à 1H. Seules les différences entre les deux procédés seront détaillées ci-après.

Le procédé des figures 3A et 3B comprend les mêmes étapes initiales que celles décrites en relation avec la figure 1A.

La figure 3A illustre une étape dans laquelle, partant de la structure de la figure 1A, on effectue, comme dans l'exemple de la figure 1B, une gravure localisée de la couche 105 de façon à ne conserver qu'une portion de la couche 105 correspondant aux futures régions de source et de drain du transistor. L'étape de gravure localisée de la figure 3A diffère de l'étape de gravure localisée de la figure 1B en ce que, dans l'étape de la figure 3A, on grave non seulement la couche 105, mais aussi la couche 103 et une partie de l'épaisseur du substrat 101 à l'aplomb des régions gravées de la couche 105.

La figure 3A illustre en outre une étape de dépôt d'un matériau isolant de remplissage 201, par exemple de l'oxyde de silicium, dans les tranchées formées par la gravure localisée des couches 105 et 103 et du substrat 101. A titre d'exemple, une couche du matériau isolant est déposée sur toute la surface supérieure de la structure obtenue après l'étape de gravure, sur une épaisseur supérieure à celle des tranchées gravées dans l'empilement comprenant les couches 105 et 103 et le substrat 101. Une étape de planarisation de la face supérieure de la structure, par exemple par polissage mécano-chimique, est ensuite mise en oeuvre de façon à retirer l'excès de matériau isolant. La planarisation est par exemple interrompue au niveau de la face supérieure de la portion de couche 105 conservée lors de l'étape de gravure.

Les étapes suivantes du procédé sont identiques ou similaires à ce qui a été décrit précédemment en relation avec les figures 1C à 1H, ou, le cas échéant, en relation avec la figure 2.

La figure 3B représente le transistor obtenu à l'issue du procédé de fabrication.

Des modes de réalisation particuliers ont été décrits. Diverses variantes et modifications apparaîtront à l'homme de l'art. En particulier, les modes de réalisation décrits ne se limitent pas aux exemples de dimensions ni aux exemples de matériaux mentionnés dans la présente description.

De plus, on notera que dans le cas où le substrat 101 est en un matériau isolant, la couche isolante 103 peut être omise.

## Revendications

1. Procédé de fabrication d'un transistor MOS, comprenant les étapes successives suivantes :
a) former une première couche (105) en un matériau conducteur ou semiconducteur sur une face d'un substrat de support ;
b) former une grille sacrificielle (107) sur la face supérieure de la première couche, et une deuxième couche (111) en un matériau isolant entourant latéralement la grille sacrificielle (107) ;
c) former, de part et d'autre de la grille sacrificielle (107), des éléments de connexion électrique (115) de source et de drain en un matériau conducteur, traversant la deuxième couche (111) et venant contacter la première couche (105) ;
d) retirer la grille sacrificielle (107) et la portion de la première couche (105) située à l'aplomb de la grille sacrificielle ;
e) déposer une troisième couche (119) en un matériau semiconducteur bidimensionnel sur les flancs et sur le fond d'une ouverture (117) formée à l'étape d) par le retrait de la grille sacrificielle (107) et de la première couche (105) ;
f) déposer une quatrième couche (121) en un matériau isolant sur la troisième couche (119) ; et
g) former une grille conductrice (123) dans l'ouverture (117), sur la quatrième couche (121).

2. Procédé selon la revendication 1, dans lequel le matériau semiconducteur bidimensionnel de la troisième couche (119) est un matériau du groupe comprenant le graphène, le siliciène, le germanène, et les dichalcogénures de métaux de transition.

3. Procédé selon la revendication 1 ou 2, dans lequel la troisième couche (119) est constituée d'un empilement de 1 à 10 feuillets cristallins bidimensionnels constitués chacun d'une seule couche d'atomes ou de molécules du matériau semiconducteur bidimensionnel.

4. Procédé selon l'une quelconque des revendications 1 à 3, dans lequel, à l'étape d), le retrait de la portion de la première couche (105) en regard de la grille sacrificielle (107) conduit à délimiter dans la première couche (105) la région de source et la région de drain du transistor.

5. Procédé selon l'une quelconque des revendications 1 à 4, dans lequel l'étape g) comprend une étape de dépôt d'un ou plusieurs matériaux conducteurs de grille sur toute la surface supérieure de la structure obtenue à l'issue de l'étape f), suivie d'une étape de planarisation par polissage mécano-chimique pour retirer le ou les matériaux conducteurs de grille en dehors de l'ouverture (117).

6. Procédé selon la revendication 5, dans lequel, aux étapes e) et f), les troisième (119) et quatrième (121) couches sont déposées sur toute la surface supérieure de la structure obtenue à l'issue de l'étape d), et dans lequel l'étape de planarisation mise en oeuvre à l'étape g) conduit à retirer les troisième (119) et quatrième (121) couches en dehors de l'ouverture (117).

7. Procédé selon l'une quelconque des revendications 1 à 6, comprenant en outre, à l'étape b), après la formation de la grille sacrificielle (107) et avant le dépôt de la deuxième couche (111), une étape de formation d'espaceurs (109) en un matériau isolant revêtant les flancs de la grille sacrificielle (107).

8. Procédé selon la revendication 7, dans lequel, à l'étape d), la grille sacrificielle (107) est retirée sélectivement par rapport aux espaceurs (109).

9. Procédé selon l'une quelconque des revendications 1 à 8, dans lequel les éléments de connexion électrique (115) de source et de drain formés à l'étape c) sont auto-alignés par rapport à la grille sacrificielle (107).

## Patentansprüche

1. Verfahren zur Herstellung eines MOS-Transistors, das die folgenden aufeinanderfolgenden Schritte aufweist:
a) Ausbilden einer ersten Schicht (105) aus einem leitenden oder halbleitenden Material auf einer Oberfläche eines Trägersubstrats;
b) Ausbilden eines Opfergates (107) auf der Oberfläche der ersten Schicht, sowie einer zweiten Schicht (111) aus einem isolierenden Material, die das Opfergate (107) seitlich umgibt;
c) Ausbilden von elektrischen Source- und Drain-Verbindungselementen (115), die aus einem leitenden Material hergestellt sind, auf beiden Seiten des Opfergates (107), welche die zweite Schicht (111) überqueren und die erste Schicht (105) kontaktieren;
d) Entfernen des Opfergates (107) und des Teils der ersten Schicht (105), der sich vertikal in einer Linie mit dem Opfergate befindet
e) Abscheiden einer dritten Schicht (119), die aus einem zweidimensionalen Halbleitermaterial besteht, an den Seiten und auf dem Boden einer Öffnung (117), die im Schritt d) durch das Entfernen des Opfergates (107) und der ersten Schicht (105) gebildet wurde;
f) Abscheiden einer vierten Schicht (121) aus einem isolierenden Material auf der dritten Schicht (119); und
g) Ausbilden eines leitenden Gates (123) in der Öffnung (117), auf der vierten Schicht (121).

2. Verfahren nach Anspruch 1, wobei das zweidimensionale Halbleitermaterial der dritten Schicht (119) ein Material aus der Gruppe ist, die Graphen, Silicen, Germanen und Übergangsmetall-Dichalcogenide aufweist.

3. Verfahren nach Anspruch 1 oder 2, wobei die dritte Schicht (119) aus einem Stapel von 1 bis 10 zweidimensionalen kristallinen Schichten gebildet wird, die jeweils aus einer einzelnen Schicht von Atomen oder von Molekülen des zweidimensionalen Halbleitermaterials gebildet werden.

4. Verfahren nach einem der Ansprüche 1 oder 3, wobei in Schritt d) das Entfernen des Abschnitts der ersten Schicht (105) gegenüber dem Opfergate (107) dazu führt, dass in der ersten Schicht (105) der Source-Bereich und der Drain-Bereich des Transistors abgegrenzt werden.

5. Verfahren nach einem der Ansprüche 1 bis 4, wobei Schritt g) einen Schritt des Abscheidens eines oder mehrerer leitender Gate-Materialien über die gesamte Oberfläche der am Ende von Schritt f) erhaltenen Struktur aufweist, gefolgt von einem Schritt der chemisch-mechanischen Planarisierung, um das/die leitende(n) Gate-Material(ien) außerhalb der Öffnung (117) zu entfernen.

6. Verfahren nach Anspruch 5, wobei in den Schritten e) und f) die dritte (119) und die vierte (121) Schicht über die gesamte Oberfläche der am Ende von Schritt d) erhaltenen Struktur abgeschieden werden, und wobei der in Schritt g) durchgeführte Planarisierungsschritt zum Entfernen der dritten (119) und vierten (121) Schicht außerhalb der Öffnung (117) führt.

7. Verfahren nach einem der Ansprüche 1 bis 6, das weiterhin im Schritt b), nach dem Ausbilden des Opfergates (107) und vor dem Abscheiden der zweiten Schicht (111), einen Schritt des Ausbilden von Abstandshaltern (109) aus einem isolierenden Material aufweist, die die Seiten des Opfergates (107) beschichten.

8. Verfahren nach Anspruch 7, wobei in Schritt d) das Opfergate (107) selektiv über den Abstandshaltern (109) entfernt wird.

9. Verfahren nach einem der Ansprüche 1 bis 8, wobei die in Schritt c) gebildeten elektrischen Source- und Drain-Verbindungselemente (115) in Bezug auf das Opfergate (107) selbstausgerichtet sind.

## Claims

1. A MOS transistor manufacturing method, comprising the successive steps of:
a) forming a first layer (105) made of a conductive or semiconductor material on a surface of a support substrate;
b) forming a sacrificial gate (107) on the upper surface of the first layer, and a second layer (111) made of an insulating material laterally surrounding the sacrificial gate (107);
c) forming, on either side of the sacrificial gate (107), source and drain electric connection elements (115) made of a conductive material, crossing the second layer (111) and contacting the first layer (105);
d) removing the sacrificial gate (107) and the portion of the first layer (105) located vertically in line with the sacrificial gate;
e) depositing a third layer (119) made of a two-dimensional semiconductor material on the sides and on the bottom of an opening (117) formed at step d) by the removal of the sacrificial gate (107) and of the first layer (105);
f) depositing a fourth layer (121) made of an insulating material on the third layer (119); and
g) forming a conductive gate (123) in the opening (117), on the fourth layer (121).

2. The method of claim 1, wherein the two-dimensional semiconductor material of the third layer (119) is a material from the group comprising graphene, silicene, germanene, and transition metal dichalcogenides.

3. The method of claim 1 or 2, wherein the third layer (119) is formed of a stack of from 1 to 10 two-dimensional crystalline sheets, each formed of a single layer of atoms or of molecules of the two-dimensional semiconductor material.

4. The method of any of claims 1 or 3, wherein, at step d), the removal of the portion of the first layer (105) opposite the sacrificial gate (107) results in delimiting in the first layer (105) the source region and the drain region of the transistor.

5. The method of any of claims 1 to 4, wherein step g) comprises a step of depositing one or a plurality of conductive gate materials over the entire upper surface of the structure obtained at the end of step f), followed by a step of chem.-mech. planarization to remove the conductive gate material(s) outside of the opening (117).

6. The method of claim 5, wherein, at steps e) and f), the third (119) and fourth (121) layers are deposited over the entire upper surface of the structure obtained at the end of step d), and wherein the planarization step implemented at step g) results in removing the third (119) and fourth (121) layers outside of the opening (117).

7. The method of any of claims 1 to 6, further comprising, at step b), after the forming of the sacrificial gate (107) and before the deposition of the second layer (111), a step of forming of spacers (109) made of an insulating material coating the sides of the sacrificial gate (107).

8. The method of claim 7, wherein, at step d), the sacrificial gate (107) is removed selectively over the spacers (109).

9. The method of any of claims 1 to 8, wherein the source and drain electric connection elements (115) formed at step c) are self-aligned with respect to the sacrificial gate (107).
